# EUROPEAN PATENT APPLICATION

(11) **EP 1 199 575 A1**
(43) Date of publication of application: **24.04.2002**
(21) Application number: 01118900.8
(22) Date of filing: 17.08.2001
(51) Int. Cl.: G01R 31/04, H01H 13/18, G01B 5/02

(54) **A testing unit and a connector testing apparatus using the same**

(30) Priority: 17.10.2000 JP 2000317068
(71) Applicant: Sumitomo Wiring Systems, Ltd., Yokkaichi-City, Mie, 510-8503 (JP)
(72) Inventor: Suzuki, Nobuhiro, Yokkaichi-city, Mie 510-8503 (JP)
(74) Representative: Müller-Boré & Partner Patentanwälte

(57) **Abstract**

[Object]

To securely detect a mounting error of a fittable member 5 on a connector.

[Solution]

A testing unit 20 for detecting an ajar state of the fittable member 5 on a housing 2 of a connector 1 is provided. This testing unit 20 is provided with an elastic contact member 22 to be elastically brought into contact with the housing 2 of the connector 1 along locking direction (Y) in which the fittable member 5 is locked with the housing 2. This elastic contact member 22 is provided with a switch member 23, which is adapted to detect the ajar state of the fittable member 5 at a contact position of the elastic contact member 22 with the housing 2.

## Description

The present invention relates to a testing unit and a connector testing apparatus using the same.

Generally, there are works having very small tolerances among industrial products and precise measurement of dimensions of such works is required.

However, dimensional deviations beyond tolerances could not be detected at a precision required in recent years by conventional projected amount detecting means.

For example, a tolerance in assembling a connector housing as a work and a fittable member (retainer or cover member) was conventionally about 0.6 mm. However, in recent years, it has been required to set this tolerance at, for example, 0.300 mm. In existing connector testing apparatuses, it has been difficult to mechanically detect dimensional deviations beyond such small dimensional tolerances due to deformation and shaking of the connector housing itself as a work.

In view of the above problem, an object of the present invention is to provide a testing unit capable of securely testing a dimensional deviation of a specific part of a work beyond its tolerance and a connector testing apparatus using such a testing unit.

This object is solved according to the invention by a testing unit according to claim 1 and by a connector testing apparatus according to claim 8. Preferred embodiments of the invention are subject of the dependent claims.

According to the present invention, there is provided a testing unit for detecting a dimensional deviation of a specific part of a work beyond its tolerance, comprising:
an elastic or resilient contact member to be elastically or resiliently brought into contact with the work, and
a detecting portion provided in or on the elastic or resilient contact member for detecting the dimensional deviation of the work at a contact position where the elastic or resilient contact member is in contact with the work.

Accordingly, in order to judge whether or not dimensions of a specific part of a work (e.g. a grommet, an outer tube or the like used for an automotive vehicle) having largely varying finished dimensions precisely conform to the specification, the elastic or resilient contact which can be brought into contact with the work is provided and is elastically or resiliently brought into contact at a specified position of the work. Accordingly, even if there is a variation in the final dimensions of the work itself or the work is shaky or deformed, the detecting portion provided in the elastic or resilient contact member can reach a proper position which serves as a reference position in detecting a dimensional deviation beyond a tolerance. Since the detecting portion detects such a dimensional deviation of the specific part of the work at this proper position (contact position of the elastic contact member with the work), the deviation can be detected as precisely as possible.

According to a preferred embodiment of the invention, the resilient contact member comprises:
an outer sleeve fixed in advance in a specific position,
an inner sleeve which is slidably mounted to the outer sleeve, has its projecting distance toward the work restricted by a stepped portion formed in the inner circumferential surface of the outer sleeve, and is resiliently held in contact with the work in such a manner as to be movable forward and backward in a testing state where the work is tested.

Preferably, the inner sleeve is slidably fitted in or on the outer sleeve.

Further preferably, a biasing member provided between the inner sleeve and the outer sleeve for biasing the inner sleeve toward the work.

Most preferably, the detecting portion comprises a switch member being preferably accommodated in the inner sleeve, which comes into contact only with the work in its proper position.

According to a further preferred embodiment, the elastic or resilient contact member comprises:
an outer sleeve fixed in advance in a specific position,
an inner sleeve which is slidably mounted to, preferably fitted in or on the outer sleeve, has its projecting distance toward the work restricted by a stepped portion formed in the inner circumferential surface of the outer sleeve, and is elastically held in contact with the work in such a manner as to be movable forward and backward in a testing state where the work is tested, and
a biasing member provided between the inner sleeve and the outer sleeve for biasing the inner sleeve toward the work, and
the detecting portion is a switch member which is accommodated in the inner sleeve and comes into contact only with the work in its proper position. In this embodiment, the elastic contact member and the detecting portion can be formed by a relatively simple construction.

In a preferable embodiment, the elastic contact member and the detecting portion are provided in a testing device of a connector testing apparatus for testing a housing of a connector. In this embodiment, a dimensional deviation of the housing beyond its tolerance can be securely detected when the housing of the connector is tested.

Most preferably, the switch member comprises a fixed pin and a movable pin being movable with respect to the fixed pin, wherein the electric relationship between the fixed pin and the movable pin is changed when the switch member comes into contact with the work being in its proper position.

According to the invention, there is further provided a connector testing apparatus for testing a connector having a fittable member which is provided with a locking portion to be locked into a housing in a locking direction arranged at an angle different from 0° or 180°, preferably substantially normal to a predetermined insertion direction by being at least partly inserted into the housing in the insertion direction, comprising:
at least one testing unit according to the invention or an embodiment thereof for testing a mounted state of the fittable member mounted on the connector.

According to a preferred embodiment of the invention, the detecting portion is provided for detecting an ajar state of the fittable member at a contact position where the resilient contact member is in contact with the housing.

Preferably, the connector testing apparatus further comprises:
a connector receptacle for holding the connector,
a testing device provided to substantially face the connector receptacle and adapted to test an electrical connection of the connector held by the connector receptacle, and
a means for relatively displacing the connector receptacle and the testing device toward and away from each other between a separated state where they are separated from each other and a testing state where they are adjacent to each other,
wherein the testing unit is provided in the testing device for testing a mounted state of the fittable member mounted on the connector held by the connector receptacle in the testing state,
wherein the elastic contact member preferably is to be elastically brought into contact with the housing of the connector held by the connector receptacle in the locking direction.

A specific embodiment of the present invention relates to a connector testing apparatus for testing a connector having a fittable member which is provided with a locking portion to be locked into a housing in a locking direction normal to a predetermined insertion direction by being inserted into the housing in the insertion direction, comprising:
a connector receptacle for holding the connector,
a testing device provided to face the connector receptacle and adapted to test an electrical connection of the connector held by the connector receptacle,
a means for relatively displacing the connector receptacle and the testing device toward and away from each other between a separated state where they are separated from each other and a testing state where they are adjacent to each other, and
a testing unit provided in the testing device for testing a mounted state of the fittable member mounted on the connector held by the connector receptacle in the testing state,
wherein the testing unit comprises an elastic contact member to be elastically brought into contact with the housing of the connector held by the connector receptacle in the locking direction, and a detecting portion provided in the elastic contact member for detecting an ajar state of the fittable member at a contact position where the elastic contact member is in contact with the housing.

Accordingly, in order to test the connector having the fittable member provided with the locking portion for locking in the specified locking direction, the testing unit for judging a mounting error of the fittable member on the housing of the connector has the elastic contact member to be elastically brought into contact with the housing in the locking direction. Accordingly, the detecting portion can follow the deformation and displacement of the housing itself in the locking direction by elastically bringing the elastic contact member into contact with the housing. Since the detecting portion provided in the elastic contact member detects an ajar state of the fittable member at the contact position of the elastic contact member with the housing, even a slight ajar state of the fittable member can be securely detected.

The fittable member may be a cover member provided with a locking member for locking terminals in the housing or a retainer for doubly locking the terminals already locked by locking portions in the housing.

These and other objects, features and advantages of the present invention will become apparent upon reading of the following detailed description of preferred embodiments and accompanying drawings in which:
FIG. 1 is a perspective view of a connector testable by the invention,
FIGS. 2(A) and 2(B) are a rear view and a side view partly cut away showing the outer configuration of the connector of FIG. 1,
FIGS. 3(A) and 3(B) are schematic enlarged partial sections showing a general state of a mounting error of a cover member as a fittable member in the connector of FIG. 1, wherein FIG. 3(A) shows a normal state and 3(B) shows a mounting-error state,
FIGS. 4(A) and 4(B) are schematic enlarged partial sections showing an other state of the mounting error of the cover member as the fittable member in the connector of FIG. 1, wherein FIG. 4(A) shows a normal state and 4(B) shows a mounting-error state,
FIG. 5 is a perspective view showing a separated state of a connector testing apparatus according to one embodiment of the invention,
FIG. 6 is a perspective view showing a testing state of the connector testing apparatus according to one embodiment of the invention,
FIG. 7 is a side view partly cut away showing the connector testing apparatus of FIG. 5,
FIG. 8 is a section of a testing device of the connector testing apparatus of FIG. 5,
FIG. 9 is a schematic enlarged partial section showing a mount testing state in the embodiment of FIG. 5, and
FIG. 10 is a schematic enlarged partial section showing a mount testing state in the embodiment of FIG. 5.

Hereinafter, a preferred embodiment of the present invention is described in detail with reference to the accompanying drawings.

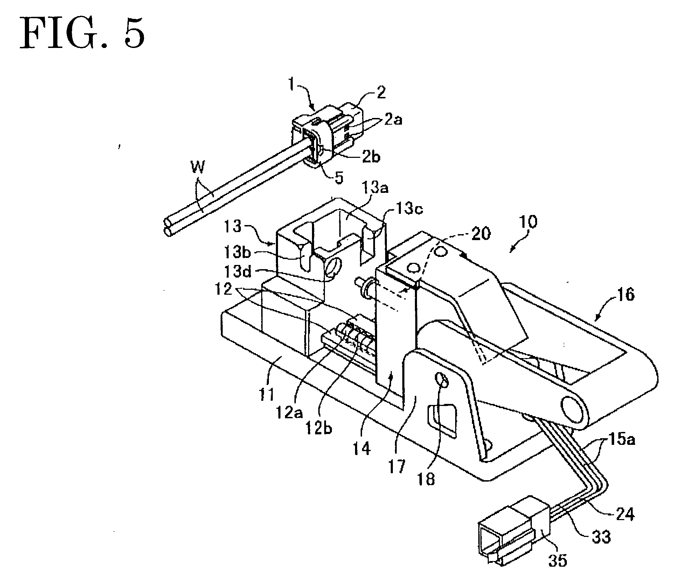

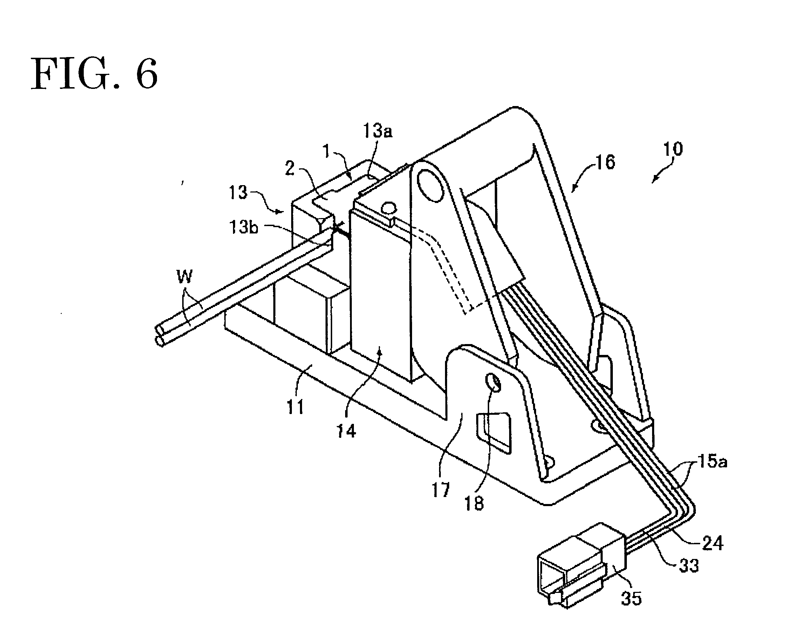

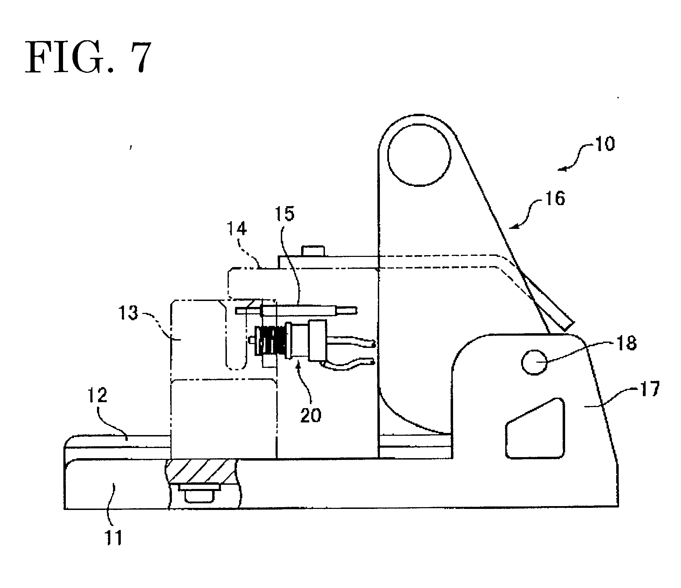

FIGS. 5 and 6 are perspective views of a connector testing apparatus 10 according to one embodiment of the present invention, wherein FIG. 5 shows a separated state and FIG. 6 shows a testing state. FIG. 7 is a side view partly cut away showing the connector testing apparatus 10 of FIG. 5 in the testing state.

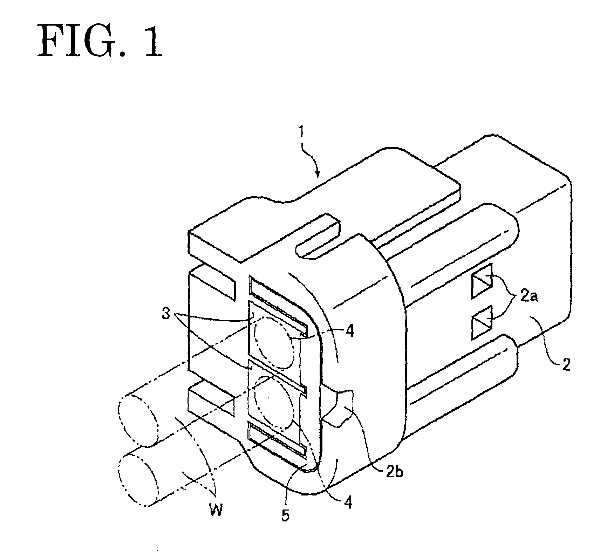

With reference to FIGS. 5 to 7, the shown connector testing apparatus 10 is adapted to test an electrical connection of a connector 1 and a mounted state of a cover member 5 shown in FIG 1.

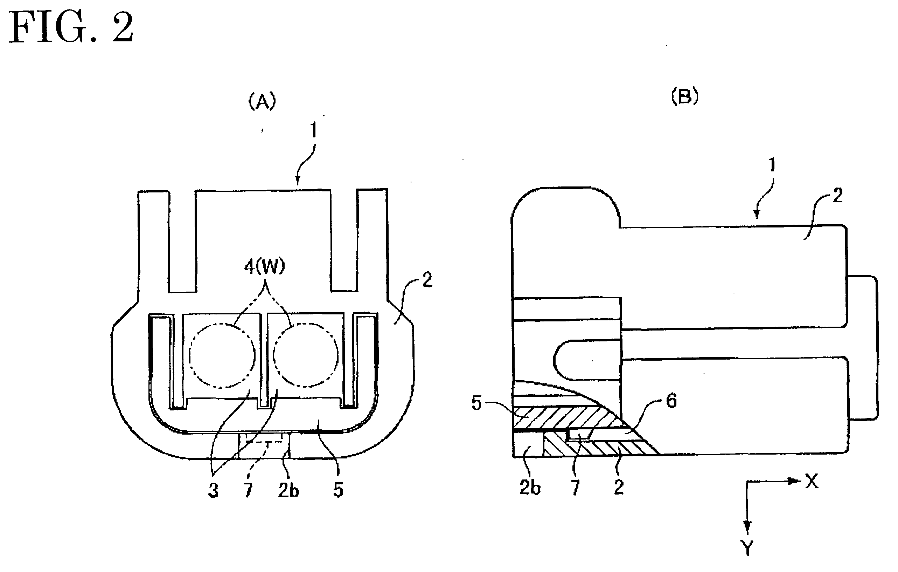

FIG. 1 is a perspective view of a connector as a work, and FIGS. 2A and 2B are a rear view and a side view partly cut away showing the outer configuration of the connector of FIG. 1.

With reference to FIGS. 1 and 2, the connector 1 of this type is comprised of a housing 2 formed e.g. of a synthetic resin material, and one or more terminals 4 to be at least partly accommodated in cavities 3 formed in the housing 2. The terminals 4 are locked or lockable in the housing 2 by flexible locking arms integrally or unitarily formed in the housing 2. The locking arms are caused to project into inner spaces of the cavities 3 and are engaged with the terminals 4 connected or connectable with wires W at a specified (predetermined or predeterminable) position to prevent the terminals 4 from coming out of the cavities 3. During insertion of the terminals 4 into the housing 2, the locking arms are elastically or resiliently deformed upon coming into contact with the terminals 4. When the terminals 4 are correctly or completely inserted, the locking arms are restored substantially to their original shapes to lock the terminals 4. Accordingly, the terminals 4 are automatically locked when being completely inserted into the housing 2.

However, the locking arms cannot be formed too large. Accordingly, there has been conventionally developed such connectors in which a cover member 5 engageable with the terminals 4 is conventionally mounted at a specified position (e.g. a rear opening continuous with the cavities 3 in the shown example) of the housing 2 after the insertion of the terminals 4, thereby doubly locking the terminals 4 in addition to the locking arms. In recent years, there has been used such connectors in which, instead of the above locking portions, a cover member which is a member separate from a housing is provided with locking portions, and terminals are locked in the housing by the locking portions of the cover member.

With reference to FIGS. 2(A) and 2(B), the cover member 5 in the shown example is a U-shaped member having a cross section corresponding to that of the housing 2 and has, at its bottom, a projection 7 engageable with a recess 6 formed at the bottom of the housing 2. In the shown example, the projection 7 of the cover member 5 is displaced in locking direction (Y) substantially normal to insertion direction (X) to be fitted into the recess 6 of the housing 2 by inserting the cover member 5 in insertion direction (X) substantially parallel to terminal-insertion direction preferably from behind the housing 2, thereby locking the cover member 5 itself. In this way, unillustrated locking portions provided in the cover member 5 lock the terminals 4. At this time, an end surface of the cover member 5 is substantially in flush with an end surface of the housing 2 with the cover member 5 mounted in a proper position.

With reference to FIGS. 5 and 6, the connector testing apparatus 10 for testing such a connector 1 is such that a pair of rails 12 are integrally so formed on a resin-made base 11 preferably substantially rectangular in plan view as to be substantially parallel with longitudinal direction, a connector receptacle 13 for holding and positioning the housing 2 of the connector 1 is fixed at one end of the rails 12, and a testing device 14 is so arranged at the other end of the rails 12 as to be relatively displaceable or slidable with respect to the connector receptacle 13.

The connector receptacle 13 includes a recess 13a into and from which the housing 2 of the connector 1 shown in FIG. 1 is vertically insertable and withdrawable preferably in a direction at an angle different from 0° or 180°, preferably substantially normal with respect to the displacement direction of the testing device 14. The housing 2 of the connector 1 to be tested is so held in the recess 13a as to be testable. In the shown example, the recess 13a is formed such that the housing 2 is placed with its longitudinal axis substantially normal to the longitudinal direction of the base 11, and so held as to cause its bottom surface to substantially face the testing device 14.

The housing 2 of the connector 1 and the cover member 5 often experience a mounting error as follows.

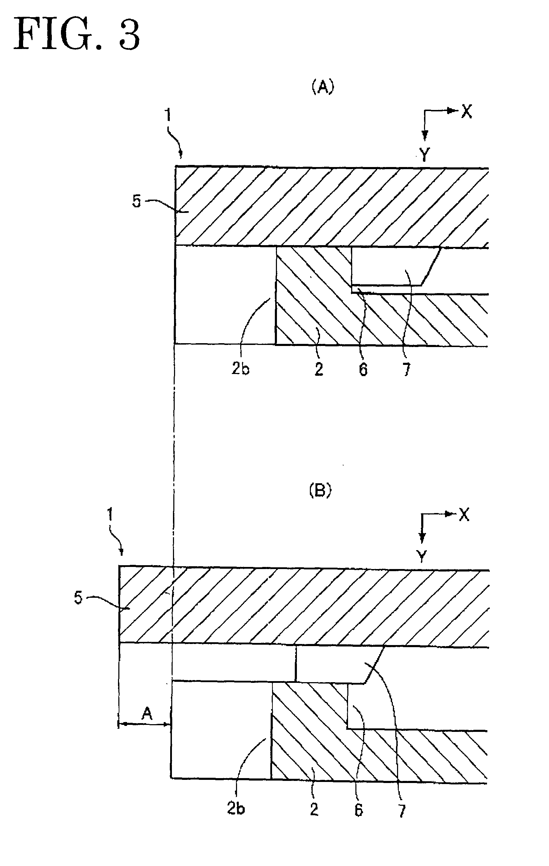

FIGS. 3(A) and 3(B) are schematic enlarged partial sections showing a general state of a mounting error of the cover member 5 as a fittable member in the connector of FIG. 1, wherein FIG. 3(A) shows a normal state and 3(B) shows a mounting-error state.

In the case of the connector 1 shown in FIGS. 1 to 3, the cover member 5 projects backward by a distance A from its proper position as shown in FIG. 3(B) if the cover member 5 is experiencing a mounting error. Accordingly, it is necessary to provide the connector testing apparatus 10 with a projected amount detecting means capable of detecting this projected amount by some method.

In the example of FIG. 5, an opening of the recess 13a is set to have dimensions and a contour which are necessary and sufficient to insert and withdraw the housing 2 preferably in its widthwise direction (vertical direction in the state shown in FIG. 1). Thus, if such a mounting error as shown in FIG. 3(B) occurs, the housing 2 can be forcibly pushed into the recess 13a if the projecting distance A or relative displacement distance A of the cover member 5 with respect to its correct locking state or normal state with respect to the housing 2 (see FIG. 3(B)) is small, whereas this mounting error is corrected or detected because the housing 2 cannot be mounted into the recess 13a if the projecting distance A is large.

Further with reference to FIG. 5, the recess 13a is formed at one side with a notch 13b for avoiding interference with the terminal-mounted wires W connected with the connector 1 held therein. On the other hand, the housing 2 is formed with an insertion hole 2a used to test an electrical connection and a notch 2b used to test a mounted state. The connector receptacle 13 is formed with a notch 13c and an opening 13d for allowing the insertion hole 2a and the notch 2b to substantially face or correspond to the testing device 14.

The testing device 14 is provided with such a number of probe pins 15 (only one is shown in FIG. 7) as (electrical) detecting elements as to correspond to contacts of the housings 2 to be tested. In the testing state shown in FIGS. 6 and 7, the probe pins 15 are brought closer to the housing 2 held in the connector receptacle 13 to come into contact with the terminals 4 inside the housing 2 through the notch 13c of the connector receptacle 13 and the insertion hole 2a of the housing 2. The probe pins 15 are connected or connectable with a plug 35 via lead wires 15a and is further connected or connectable with an unillustrated electrical connection testing apparatus via this plug 35. Further, the testing device 14 is guided in the longitudinal direction of the base 11 by a guide bar 12a provided between the pair of rails 12, and is constantly biased toward a toggle lever 16 by arranging a coil spring 12b mounted on the guide bar 12a between the connector receptacle 13 and the testing device 14.

This toggle lever 16 is provided at an end point at the other end of the rails 12. By rotating or pivoting the toggle lever 16 about a pin 18 penetrating through mounting plate portions 17 extending from the base 11, the testing device 14 can be brought to the testing state and to the separated state so as to enable an electrical connection test similar to a known apparatus.

In the above construction, a testing unit 20 for testing the cover member 5 of the connector 1 held in the connector receptacle 13 is arranged in the testing device 14. This testing unit 20 is adapted to detect a slight ajar state (or misalignment or mispositioned or opening state) of the cover member 5 with respect to the housing 2 of the connector 1.

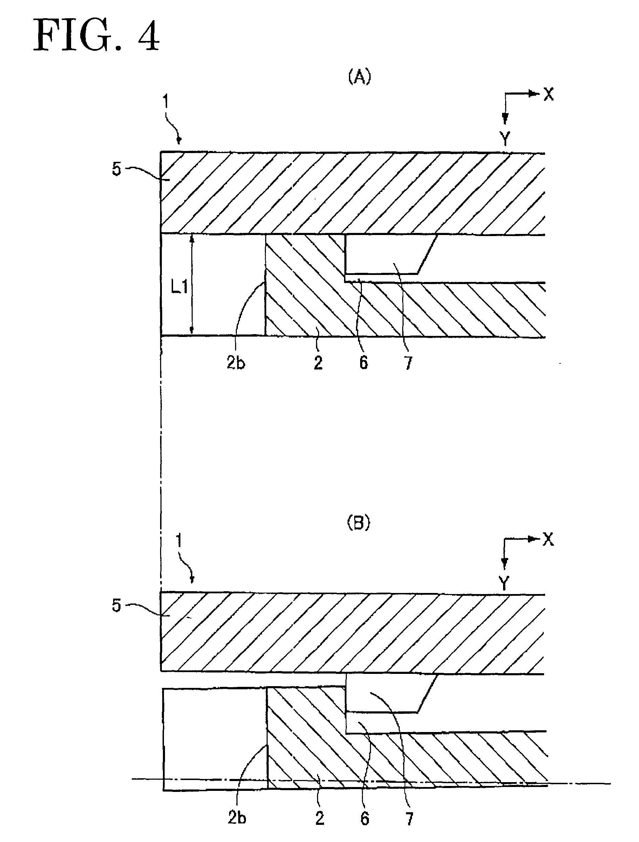

FIGS. 4(A) and 4(B) are schematic enlarged partial sections showing an other state of the mounting error of the cover member 5 as the fittable member in the connector of FIG. 1, wherein FIG. 4(A) shows a normal state and 4(B) shows a mounting-error state.

As shown in FIGS. 4(A) and 4(B), the mounting error of the connector 1 may result in an ajar state (or misalignment or mispositioned or opening state) of the cover 5 projecting in locking direction (Y) substantially normal to insertion direction (X) despite the fact that the cover member 5 is inserted to its proper insertion position.

In this embodiment, a pin-shaped testing member is or can be inserted through the notch 2b formed at the bottom of the housing 2 to face the cover member 5. If the cover member 5 is ajar (or misaligned or mispositioned or opened), the testing member cannot be brought into contact with the cover member 5 even in the testing state where the connector receptacle 13 and the testing device 14 are adjacent to each other. In other words, whether or not the cover member 5 is properly mounted is mechanically tested. Even if an attempt is made to detect the above ajar state using a known switch pin, detectable dimensional precision was at most about 0.6 mm due to deformation, shaking or variations of finished dimensions of the housing 2 itself. In this respect, an error can be detected at a dimensional precision of about 0.30 mm in this embodiment by adopting the following construction.

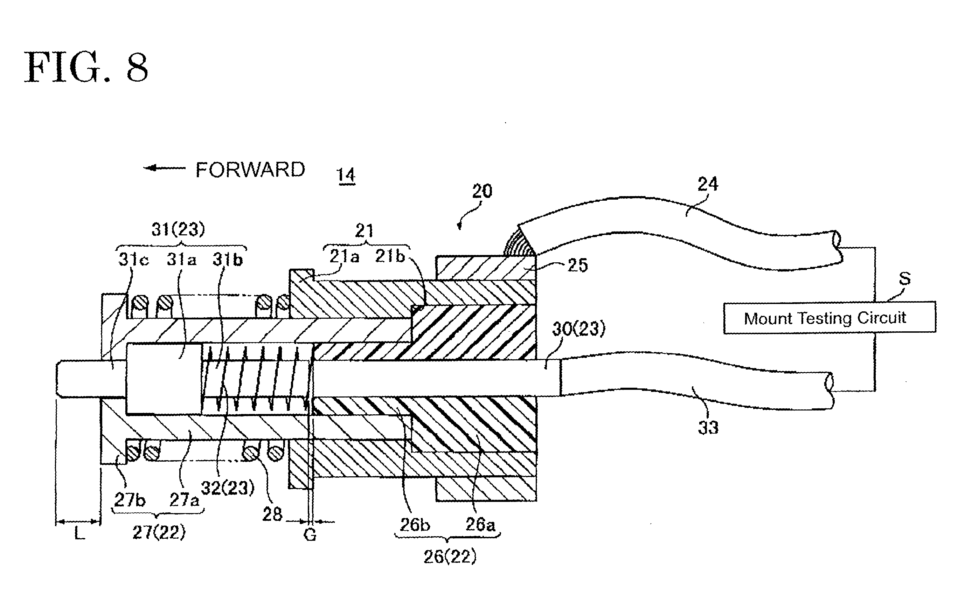

FIG. 8 is a section showing the testing unit 20 of the connector testing apparatus 10 shown in FIG. 5.

With reference to FIG. 8, the testing unit 20 includes an outer sleeve 21 formed of an electrically conductive material and fixed or mountable to the testing device 14, an inner sleeve 22 slidably or movably at least partly arranged in the outer sleeve 21, and a switch pin 23 as a detector at least partly arranged in the inner sleeve 22. The elements 21, 22 and 23 preferably are substantially concentrically arranged. In the following description, a direction in which the testing device 14 is facing the connector receptacle 13 is assumed to be a forward direction.

The outer sleeve 21 is a structural member secured to the testing device 14, and a conductive ring 25 to which a lead wire 24 to be connected with a mount testing circuit S of an unillustrated electrical connection testing apparatus is soldered is pressingly mounted on the outer circumference of the rear end of the outer sleeve 21. A flange 21 a is formed at the front end surface of the outer sleeve 21. A stepped portion 21b for specifying a projecting position of the inner sleeve 22 is formed in the inner circumferential surface of the outer sleeve 21. This stepped portion 21b has a larger diameter at its rear part, so that the front end of the inner sleeve 22 is received by the back surface of the stepped portion 21 b.

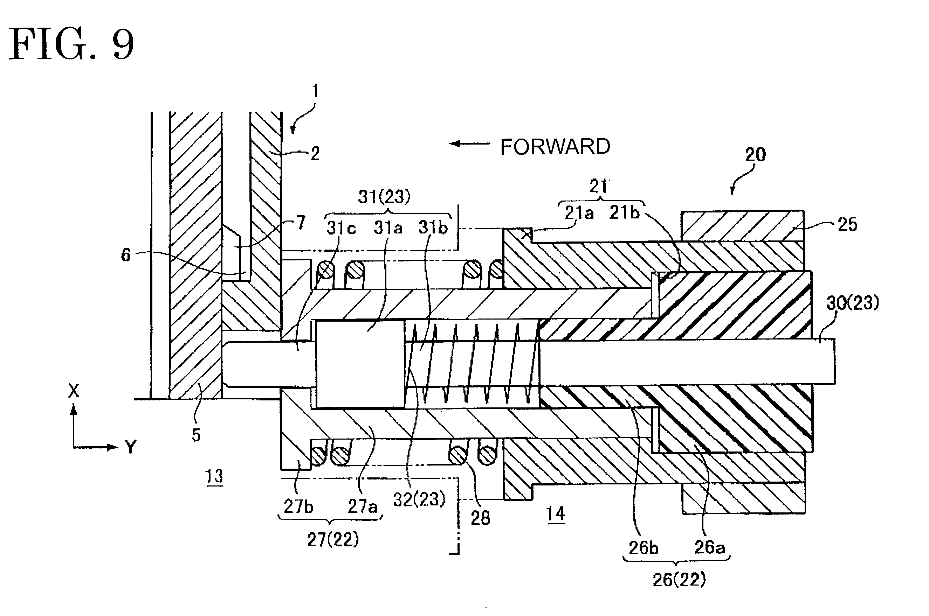

The inner sleeve 22 is a unit in which an insulating sleeve 26 and a conductive sleeve 27 are substantially concentrically made integral. The insulating sleeve 26 integrally or unitarily includes a large-diameter portion 26a which is slidably arranged at the rear end portion of the outer sleeve 21 in such a manner that it can come into contact with the stepped portion 21b of the outer sleeve 21, and a small-diameter portion 26b substantially concentrically formed with the large-diameter portion 26a. The conductive sleeve 27 integrally includes a tubular portion 27a having the small-diameter portion 26b of the insulating sleeve 26 pressed into its rear end portion, and a flange 27b formed at the front end of the tubular portion 27a. A coil spring 28 mounted on the conductive sleeve 27 is provided between the flange 27b and the flange 21a of the outer sleeve 21. The inner sleeve 22 is entirely biased forward by this coil spring 28 to project up to a position defined by the stepped portion 21b. Thus, the inner sleeve 22 can be elastically brought into contact with the housing 2 of the connector 1 during a mounted-state testing to be described later to adjust a position where the switch pin 23 described next comes into contact with the cover member 5 (see FIG. 9).

The switch pin 23 is such that a switch member is formed by a fixed pin 30 pressed into or mounted to the insulating sleeve 26 of the inner sleeve 22, a movable pin 31 slidably arranged in longitudinal direction in the conductive sleeve 27 and a coil spring 32 for biasing the movable pin 31 forward.

The fixed pin 30 is an electrically conductive member which is integral to the insulating sleeve 26 with its front end held in flush with the end surface of the small-diameter portion 26b of the insulating sleeve 26. The rear end of the fixed pin 30 projects slightly more backward than the insulating sleeve 26, and a lead wire 33 connected with the mount testing circuit S is soldered to this rear end.

The movable pin 31 is an electrically conductive member which integrally includes a large-diameter portion 31a held in sliding contact with the inner circumferential surface of the conductive sleeve 27, a connecting portion 31b substantially concentrically projecting at the rear end of the large-diameter portion 31a, and a small-diameter contact portion 31c substantially concentrically projecting at the front end of the large-diameter portion 31a. The movable pin 31 forms a so-called A-contact in cooperation with the fixed pin 30.

The large-diameter portion 31a supports the entire movable pin 31 in the conductive sleeve 27 and electrically connects the movable pin 31 with the conductive sleeve 27. This large-diameter portion 31a is held in contact with the inner end wall of the conductive sleeve 27 by being biased forward by the coil spring 32. The connecting portion 31b is a portion for forming a contact with the fixed pin 30 and, in the shown example, is opposed to the fixed pin 30 while defining a gap G therebetween with the large-diameter portion 31 a held in contact with the inner end wall of the conductive sleeve 27. The gap G serves as a displacement stroke of the movable pin 31.

The contact portion 31c is a member which comes into contact with the cover member 5 of the connector 1 during the mounted-state testing to be described later (see FIG 9). A projecting length L of the contact portion 31c from the conductive sleeve 27 is precisely set to correspond to a distance L1 (see FIG. 4A) from the bottom surface of the housing 2 of the connector 1 to be tested to the bottom surface of the cover member 5, so that, only upon contacting the bottom surface of the cover member 5 in its proper position, the contact portion 31c is slightly displaced backward to connect the connecting portion 31b with the fixed pin 30.

The fixed pin 30 of the switch pin 23 is connected with the mount testing circuit S by the lead wire 33, and the movable pin 31 thereof is connected therewith via the conductive sleeve 27, the outer sleeve 21, the conductive ring 25 and the lead wire 24. The mount testing circuit S can detect the ajar state (or misalignment or mispositioned or opening state) of the cover member 5 by detecting whether or not the pins 30, 31 are in contact with each other. The lead wires 24, 33 are connected with the plug 35 shown in FIG. 5 and are connected with the mount testing circuit S via this plug 35.

Next, the function of this embodiment is described.

In the above construction, the toggle lever 16 is laid down to leave the connector receptacle 13 and the testing device 14 separated from each other as shown in FIG. 5. In this state, the connector 1 is properly mounted in the recess 13a of the connector receptacle 13. During this mounting, the mounting error as shown in FIG. 3(B) can be corrected or detected by suitably setting the dimensions at the opening of the recess 13a.

Next, the toggle lever 16 is raised to bring the testing device 14 and the connector receptacle 13 adjacent to each other to a testing state. In this testing state, the terminals 4 of the connector 1 held in the connector receptacle 13 are brought into contact with the corresponding probe pins 15, thereby conducting an electrical connection test as is known. Simultaneously, the ajar state of the cover member 5 of the connector 1 is checked by the testing device 20 in the shown embodiment.

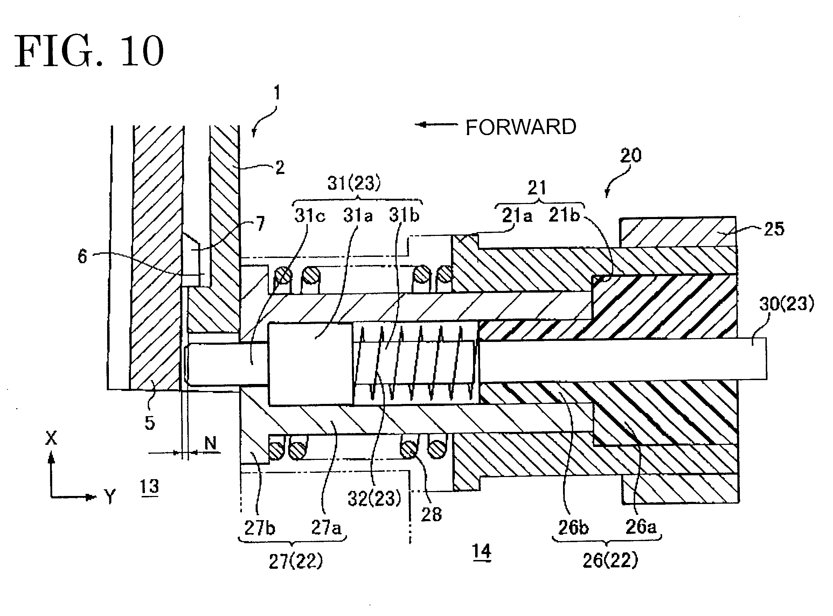

FIGS. 9 and 10 are schematic enlarged partial sections showing a mount testing state in the embodiment of FIG. 5.

First, with reference to FIG. 9, when a proper connector 1 is to be tested, the testing device 14 is displaced to its testing position to elastically bring the conductive sleeve 27 of the outer sleeve 22 of the testing unit 20 into contact with the housing 2 of the connector 1. On the other hand, the movable pin 31 of the switch pin 23 projecting from the shown contact position is retracted backward when the contact portion 31 c comes into contact with the bottom surface of the cover member 5 mounted in a proper position because the dimensions are set as described with reference to FIG. 8, thereby being electrically connected with the fixed pin 30. In this way, the contact formed by the pins 30, 31 is closed to be electrically connected, and this state is detected by the mount testing circuit S, which can in turn discriminate the connector 1 to be a good product. Here, by setting the contact position of the inner sleeve 22 with the housing 2 at a position where the inner sleeve 22 is retracted backward in advance, dimension-varying factors such as deformation of the housing 2 itself and shaking in the connector receptacle 13 can be taken up by the inner sleeve 22, with the result that the switch pin 23 can be precisely positioned.

Next, with reference to FIG. 10, even if the cover member 5 of the connector 1 is experiencing a mounting error shown in FIG. 4(B), the inner sleeve 22 comes into contact with the bottom surface of the housing 2 as in the case where the cover member 5 is properly mounted. However, since a distance between the bottom surface of the housing 2 and the bottom surface of the cover member 5 is larger than a proper distance, the contact portion 31c projecting from the inner sleeve 22 cannot reach the bottom surface of the cover member 5 even if a dimensional difference (projecting distance N shown in FIG. 10) is a very small value of about 0.300 mm. This leaves the contact formed by the respective pins 30, 31 open. As a result, the mount testing circuit S (see FIG. 8) can detect the mounting error of the cover member 5.

As described above, according to this embodiment, the ajar state of the cover member 5 in locking direction can be securely detected by providing the testing unit 20. Thus, the testing performance of the connector testing apparatus 10 is improved, thereby improving its reliability.

The aforementioned embodiment is merely an illustration of a preferable specific example of the present invention, and the present invention is not limited to the foregoing embodiment. Particularly, the testing unit according to the present invention can test not only the connector, but also various other works, such as other types of housings, fuse boxes, protections, etc.

It should be appreciated that various other design changes can be made without departing from the scope of the present invention as claimed.

As described above, the present invention has a remarkable effect of securely detecting a dimensional deviation of a specified part of a work from its tolerance even if the work is experiencing a deformation and/or displacement. Thus, according to the present invention, testing performance and reliability can be improved.

### LIST OF REFERENCE NUMERALS

- 1 ...: connector (example of a work)
- 2 ...: housing
- 5 ...: cover member (example of a fittable member)
- 7 ...: projection (locking member)
- 10 ...: connector testing apparatus
- 13 ...: connector receptacle
- 13a ...: recess
- 14 ...: testing device
- 20 ...: testing unit
- 21 ...: outer sleeve
- 22 ...: inner sleeve (element of an elastic contact member)
- 23 ...: switch pin (element of a detecting portion/switching member)
- 28 ...: coil spring (element of the elastic contact member)
- 30 ...: fixed pin (element of the switching member)
- 31 ...: movable pin (element of the switching member)
- 32 ...: coil spring (element of the switching member)
- L1 ...: dimension of a specific part
- S ...: mount testing circuit
- X ...: insertion direction
- Y ...: locking direction

## Claims

1. A testing unit (20) for detecting a dimensional deviation (N) of a specific part (2, 5) of a work (1) beyond its tolerance, comprising:
a resilient contact member (22) to be resiliently brought into contact with the work (1), and
a detecting portion (23) provided on the resilient contact member (22) for detecting the dimensional deviation (N) of the work (1) at a contact position where the resilient contact member (22) is in contact with the work (1).

2. A testing unit according to claim 1, wherein the resilient contact member (22) comprises:
an outer sleeve (21) fixed in advance in a specific position,
an inner sleeve (22) which is slidably mounted to the outer sleeve (21), has its projecting distance toward the work restricted by a stepped portion (21b) formed in the inner circumferential surface of the outer sleeve (21), and is resiliently held in contact with the work (1) in such a manner as to be movable forward and backward in a testing state where the work (1) is tested.

3. A testing unit according to claim 2, wherein the inner sleeve (22) is slidably fitted in the outer sleeve (21).

4. A testing unit according to claim 2 or 3, wherein a biasing member (28) provided between the inner sleeve (22) and the outer sleeve (21) for biasing the inner sleeve (22) toward the work (1).

5. A testing unit according to one or more of the preceding claims, wherein the detecting portion (23) comprises a switch member (23) being preferably accommodated in the inner sleeve (22), which comes into contact only with the work (1) in its proper position (FIG. 9).

6. A testing unit according to claim 5, wherein the switch member (23) comprises a fixed pin (30) and a movable pin (31) being movable with respect to the fixed pin (30), wherein the electric relationship between the fixed pin (30) and the movable pin (31) is changed when the switch member (23) comes into contact with the work (1) being in its proper position (FIG. 9).

7. A connector testing apparatus (10) for testing a connector (1) having a fittable member (5) which is provided with a locking portion (7) to be locked into a housing (2) in a locking direction (Y) arranged at an angle different from 0° or 180°, preferably substantially normal to a predetermined insertion direction (X) by being at least partly inserted into the housing (2) in the insertion direction (X), comprising:
at least one testing unit (20) according to one or more of the preceding claims for testing a mounted state of the fittable member (5) mounted on the connector (1).

8. A connector testing apparatus according to claim 8, wherein the detecting portion (23) is provided for detecting an ajar state (FIG. 10) of the fittable member (5) at a contact position where the resilient contact member (22) is in contact with the housing (2).

9. A connector testing apparatus according to claim 8 or 9, further comprising:
a connector receptacle (13) for holding the connector (1),
a testing device (14) provided to substantially face the connector receptacle (13) and adapted to test an electrical connection of the connector (1) held by the connector receptacle (13), and
a means (11; 12; 16; 18) for relatively displacing the connector receptacle (13) and the testing device (14) toward and away from each other between a separated state (FIG. 5) where they are separated from each other and a testing state (FIGS. 6; 7) where they are adjacent to each other,
wherein the testing unit (20) is provided in the testing device (14) for testing a mounted state of the fittable member (5) mounted on the connector (1) held by the connector receptacle (13) in the testing state (FIGS. 6; 7),
wherein the elastic contact member (22) preferably is to be elastically brought into contact with the housing (2) of the connector (1) held by the connector receptacle (13) in the locking direction (X).
